# EUROPEAN PATENT APPLICATION

(11) **EP 4 134 554 A1**
(43) Date of publication of application: **15.02.2023**
(21) Application number: 22189156.7
(22) Date of filing: 07.08.2022
(51) Int. Cl.: F04D 29/60, F04D 25/06, F04D 25/16

(54) **A MODULAR MAGNETIC-TYPE FAN CONVENIENT FOR INSTALLATION**

(30) Priority: 09.08.2021 CN 202121852034 U
(71) Applicant: Guangzhou Zeta Science Technology Co., Ltd., Guangzhou, Guangdong 510000 (CN)
(72) Inventor: FANG, Anding, Guangzhou, Guangdong, 510000 (CN)
(74) Representative: Wang, Bo

(57) **Abstract**

The present utility model discloses a modular magnetic-type fan convenient for installation, which comprises a housing, a magnetic-type structure and an electrical-connection structure; the housing is surrounded by a plurality of side frames; the magnetic-type structure comprises a first magnetic part and a second magnetic part arranged on both side frames; the first magnetic part and the second magnetic part are arranged adjacently or oppositely; the electrical-connection structure comprises a first electrical-connection part and a second electrical-connection part arranged on two side frames; the first electrical-connection part and the first magnetic part are located on the same side frame, and the second electrical-connection part and the second magnetic part are on the same side frame. When it is necessary to combine a plurality of fans, the first magnetic part and the second magnetic part on two adjacent housings attract each other so that the two housings fix each other, the first electrical-connection part and the second electrical-connection part are in contact with each other so as to realize the electrical connection of the two fans and form a building-block-type combination; the users can splice fans in accordance with their actual needs make the fan combinations more convenient and avoid messy electrical connection.

## Description

### TECHNICAL FIELD

The present utility model relates to the field of computer fans, in particular relates to a modular magnetic-type fan convenient for installation.

### BACKGROUND ART

The computer fans are also called cooling fans, generally used for heat dissipation. The computer fans are provided for radiators and computer cases. The general cooling fans on the market range from 2.5cm to 30cm in diameter and from 6mm to 76mm in thickness; such fans are equipped with rare AC (alternating current, powered by household sockets) and common DC (direct current, powered by computer transformers or mainboards) in accordance with different running requirements; most of such fans are equipped with two-phase motors (two groups of copper coils, with four units in total), such design is conducive to saving production costs on the premise that the revolving speed is not high.

With the upgrading of computer hardware (graphics card, CPU), their working frequency also become higher. Therefore, the heat dissipation of a single fan cannot realize the expected heat dissipation, resulting in hardware damage. Therefore, generally, a plurality of single fans are connected in series through wires or the interfaces of the single fans are connected with the power supply in order to realize the multi-fan operation and achieve the expected heat dissipation. However, such structure results in more and messy electrical connection in a computer and thus easily results in unstable operation of fans. Without doubt, there are also integrated multi-position fans. However, when it is considered that there are two fan positions, the applicability of integrated three-position fans is poor because it is impossible to configure such fans as per users' requirements, namely great limitations. However, in some installations, the fans cannot be installed with each other due to positions (the installation of a single fan is limited by the position and a plurality of fans cannot be installed as one).

### SUMMARY OF UTILITY MODEL

The main purpose of the present utility model is to propose a modular computer magnetic-type fan so that a single fan can be configured as per the actual needs and take on a stable and simple structure without multiple-circuit connection.

To achieve the purpose described above, the present utility model provides a modular magnetic-type fan convenient for installation, which comprises:
a housing, which is surrounded by a plurality of side frames;
a magnetic-type structure, which comprises a first magnetic part and a second magnetic part arranged on both side frames, the first magnetic part and the second magnetic part are arranged adjacently or oppositely;
an electrical-connection structure, which comprises a first electrical-connection part and a second electrical-connection part arranged on two side frames; the first electrical-connection part and the first magnetic part are located on the same side frame, and the second electrical-connection part and the second magnetic part are on the same side frame;
when there are two housings, the two housings fit mutually through first magnetic part and the second magnetic part to realize the connection of the first electrical-connection part with the second electrical-connection part.

Preferably, the housing is rectangular, the first magnetic part and the second magnetic part are arranged oppositely.

Preferably, the side frame designed with the first magnetic part and the side frame designed with the second magnetic part are designed with a locating groove and a locating block respectively, and the locating block can be wedged into the locating groove.

Preferably, the locating groove is arranged in the lengthwise direction of the side frame.

Preferably, both sides of the first electrical-connection part are designed with guide grooves, both sides of the second electrical-connection part are designed with guide parts matching up with the guide grooves.

Preferably, the first electrical-connection part comprises a plurality of electrical-connection sheets and the second electrical-connection part is an elastic contact pin of slidable installation.

Preferably, the housing comprises an upper part of housing and a lower part of housing, a first limiting groove is located between the upper part of housing and the lower part of housing, the first magnetic part or the second magnetic part is wedged into the first limiting groove.

Preferably, a second limiting groove is located between the upper part of housing and the lower part of housing, the electrical-connection sheets or the elastic contact pin is wedged into the second limiting groove.

Preferably, the first electrical-connection part and the second electrical-connection part located in the same housing are electrically connected through wires or PCBs.

As a technical solution of the present utility model that: when it is necessary to combine a plurality of fans, the first magnetic part and the second magnetic part on two adjacent housings attract each other so that the two housings fix each other, the first electrical-connection part and the second electrical-connection part are in contact with each other so as to realize the electrical connection of the two fans and form a building-block-type combination; the users can splice fans in accordance with their actual needs make the fan combinations more convenient and avoid messy electrical connection.

### BRIEF DESCRIPTION OF DRAWINGS

FIG. 1 is a schematic diagram that two fans of the present utility model fit each other;
FIG. 2 is a cutaway view of the present utility model;
FIG. 3 is one vertical schematic diagram of the present utility model;
FIG. 4 is another vertical schematic diagram of the present utility model.

In the figures, 1-housing; 10-side frame; 11-upper part of the housing; 12-lower part of the housing; 21-first magnetic part; 22-second magnetic part; 31-first electrical-connection part; 32-second electrical-connection part; 41-locating groove; 42-locating block; 51-first limiting groove; 52-second limiting groove; 61-guide groove; 62-guide part.

### DETAILED EMBODIMENTS

The technical solutions of the present utility model will be described more clearly and fully in conjunction with the accompanying drawings of the present utility model, and obviously, the described embodiments are merely a part of the embodiments of the present utility model, not all the embodiments. Based on the embodiments of the present utility model, all the other embodiments obtained by the ordinary skilled in the art without creative labors belong to the scope claimed by the present utility model.

It should be noted that if an embodiment of the present utility model relates to directive instructions (such as upper, lower, left, right, front, rear, top, bottom, inside, outside, vertical, transverse, longitudinal, counter-clockwise, clockwise, circumferential, radial and axial), these directive instructions are merely used to explain the relative position relationship, the movement and so on among the components at certain specific posture (as shown in the accompanying drawings); if the specific posture changes, the directive instructions should be changed accordingly.

In addition, if an embodiment of the present utility model relates to the descriptions such as "first" and "second", these descriptions are merely used for description and should not be understood to indicate or imply their relative importance or implicitly indicate the number of the corresponding technical features. This shows that the features limited with "first" and "second" can explicitly or implicitly include one such feature at least. Moreover, the technical solutions among the embodiments can be in combination with each other; however, such combination must be on the premise that those skilled in the art can realize the related technical solutions; when the technical solutions are inconsistent or cannot be realized, such combination of technical solutions should be deemed to be inexistent and not in the scope claimed by the present utility model.

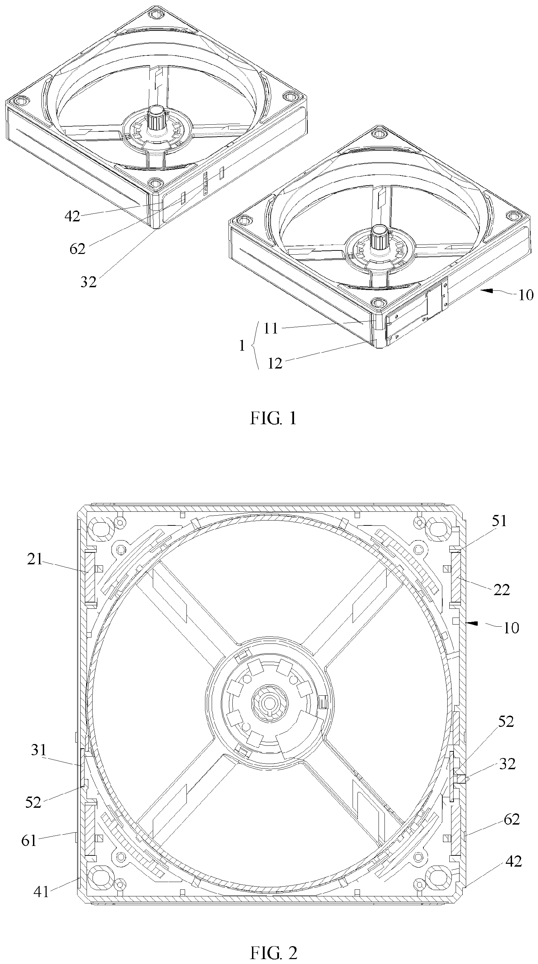

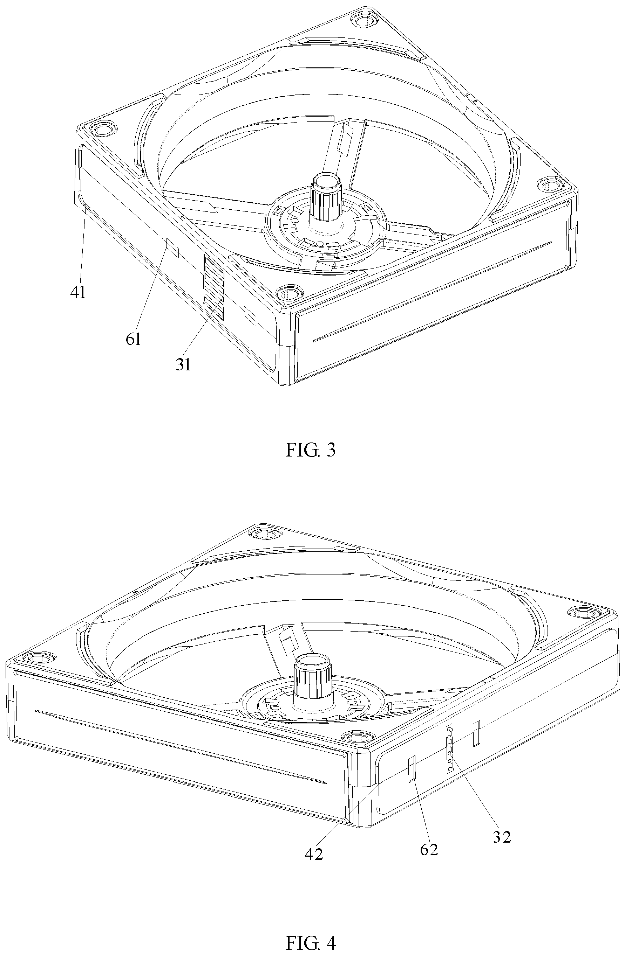

As shown from FIG. 1 to FIG. 4, a modular magnetic-type fan convenient for installation comprises:
a housing (1) which is surrounded by a plurality of side frames (10);
a magnetic-type structure, which comprises a first magnetic part (21) and a second magnetic part (22) arranged on both side frames (10), the first magnetic part (21) and the second magnetic part (22) are arranged adjacently or oppositely;
an electrical-connection structure, which comprises a first electrical-connection part (31) and a second electrical-connection part (31) arranged on two side frames (10); the first electrical-connection part (31) and the first magnetic part (21) are located on the same side frame (10), and the second electrical-connection part (32) and the second magnetic part (22) are on the same side frame (22);
when there are two housings (1), the two housings (1) fit mutually through first magnetic part (21) and the second magnetic part (22) to realize the connection of the first electrical-connection part (31) with the second electrical-connection part (32).

When it is necessary to combine a plurality of fans, the first magnetic part (21) and the second magnetic part (22) on two adjacent housings (1) attract each other so that the two housings fix each other, the first electrical-connection part (31) and the second electrical-connection part (32) are in contact with each other so as to realize the electrical connection of the two fans and form a building-block-type combination; the users can splice fans in accordance with their actual needs make the fan combinations more convenient (meaning that the fans can be spliced and fixed mutually just after being placed directly) and avoid messy electrical connection.

In an embodiment of the present utility model, the housing (1) is rectangular, the first magnetic part (21) and the second magnetic part (22) are arranged oppositely so that the housing (1) can be overlaid in the same direction; the first magnetic part (21) and the second magnetic part (22) also can be arranged adjacently so the fans can be overlaid in any direction (e.g. The fans are arranged at the positions of corners).

In an embodiment of the present utility model, the side frame (10) designed with the first magnetic part (21) and the side frame (10) designed with the second magnetic part (22) are designed with a locating groove (41) and a locating block (42) respectively, and the locating block (42) can be wedged into the locating groove (41); the cooperation of the locating groove (41) with the locating block (42) forms a limiting position between two parts of the housing (1) to prevent the first magnetic part (21) and the second magnetic part (22) from external force which causes one of the parts of the housing (1) to sliding and makes the two parts attract more stably. The locating groove and the locating block can be swapped as per the actual situation.

In an embodiment of the present utility model, the locating groove (41) is arranged in the lengthwise direction of the side frame (10) and enables the force bearing point between the two parts of the housing (1) become more stable and thus prevents the force at a single position

In an embodiment of the present utility model, both sides of the first electrical-connection part (31) are designed with guide grooves (61), both sides of the second electrical-connection part (32) are designed with guide parts (62) matching up with the guide grooves (61); the design of the guide grooves (61) and the guide parts (62) can further prevent the first electrical-connection part (31) and the second electrical-connection part (32) from dislocation and thus enables the first electrical-connection part (31) and the second electrical-connection part (32) to accurately aim at target positions. The guide grooves and the guide parts (62) can be swapped as per the actual situation.

In an embodiment of the present utility model, the first electrical-connection part (31) comprises a plurality of electrical-connection sheets and the second electrical-connection part (32) is an elastic contact pin of slidable installation, wherein the electrical-connection sheets mainly comprise light control, power connection and fan speed control.

In an embodiment of the present utility model, the housing (1) comprises an upper part of housing (11) and a lower part of housing (12); a first limiting groove (51) is designed between the upper part of housing (11) and the lower part of housing (12), the first magnetic part (21) or the second magnetic part (22) is wedged into the first limiting groove (51) for the convenience of installing and fixing the first magnetic part (21) and the second magnetic part (22); permanent magnets are preferable.

In an embodiment of the present utility model, a second limiting groove (52) is located between the upper part of housing (11) and the lower part of housing (12), the electrical-connection sheets or the elastic contact pin is wedged into the second limiting groove (52).

In an embodiment of the present utility model, the first electrical-connection part (31) and the second electrical-connection part (32) located in the same housing are connected through wires or PCBs to reduce the use of wires and realize more convenient arrangement and installation of fans; adjacent positions can realize the shortest circuit design, but the number and arrangement of fans are limited to a relatively large extent (mainly appropriate for overlaying two fans).

The embodiments described above are merely the preferred embodiments of the present utility model, not to limit the patent scope of the present utility model; with the conception of the present utility model, any equivalent structure transformation using the Specifications and the accompanying drawings of the present utility model or direct/indirect applications to other related technical fields should be included in the scope claimed by the present utility model.

## Claims

1. A modular magnetic-type fan convenient for installation, wherein it comprises:
a housing, which is surrounded by a plurality of side frames;
a magnetic-type structure, which comprises a first magnetic part and a second magnetic part arranged on both side frames, the first magnetic part and the second magnetic part are arranged adjacently or oppositely;
an electrical-connection structure, which comprises a first electrical-connection part and a second electrical-connection part arranged on two side frames; the first electrical-connection part and the first magnetic part are located on the same side frame, and the second electrical-connection part and the second magnetic part are on the same side frame;
when there are two housings, the two housings fit mutually through first magnetic part and the second magnetic part to realize the connection of the first electrical-connection part with the second electrical-connection part.

2. The modular magnetic-type fan convenient for installation in accordance with Claim 1, wherein the housing is rectangular, the first magnetic part and the second magnetic part are arranged oppositely.

3. The modular magnetic-type fan convenient for installation in accordance with Claim 2, wherein the side frame designed with the first magnetic part and the side frame designed with the second magnetic part are designed with a locating groove and a locating block respectively, and the locating block can be wedged into the locating groove.

4. The modular magnetic-type fan convenient for installation in accordance with Claim 3, wherein the locating groove is arranged in the lengthwise direction of the side frame.

5. The modular magnetic-type fan convenient for installation in accordance with Claim 1, wherein both sides of the first electrical-connection part are designed with guide grooves, both sides of the second electrical-connection part are designed with guide parts matching up with the guide grooves.

6. The modular magnetic-type fan convenient for installation in accordance with Claim 1, wherein the first electrical-connection part comprises a plurality of electrical-connection sheets and the second electrical-connection part is an elastic contact pin of slidable installation.

7. The modular magnetic-type fan convenient for installation in accordance with Claim 1, wherein the housing comprises an upper part of housing and a lower part of housing, a first limiting groove is located between the upper part of housing and the lower part of housing, the first magnetic part or the second magnetic part is wedged into the first limiting groove.

8. The modular magnetic-type fan convenient for installation in accordance with Claim 7, wherein a second limiting groove is located between the upper part of housing and the lower part of housing, the electrical-connection sheets or the elastic contact pin is wedged into the second limiting groove.

9. The modular magnetic-type fan convenient for installation in accordance with Claim 1, wherein the first electrical-connection part and the second electrical-connection part located in the same housing are electrically connected through wires or PCBs.
